# EUROPÄISCHE PATENTANMELDUNG

(11) **EP 2 461 657 A1**
(43) Veröffentlichungstag der Anmeldung: **06.06.2012**
(21) Anmeldenummer: 10193453.7
(22) Anmeldetag: 02.12.2010
(51) Int. Cl.: H05K 3/28, H05K 9/00

(54) **Elektrische Baugruppe und Verfahren zur Herstellung einer elektrischen Baugruppe**

(71) Anmelder: SIEMENS AKTIENGESELLSCHAFT, 80333 München (DE)
(72) Erfinder: Seebahn, Björn, 91058 Erlangen (DE)

(57) **Zusammenfassung**

Die Erfindung betrifft eine elektrische Baugruppe, wobei die Baugruppe (1) eine Leiterplatte (5) und auf der Leiterplatte (5) angeordnete elektrische Bauelemente (2,3a,3b) aufweist, wobei die Leiterplatte (5) elektrisch leitende Leiterbahnen (4a,4b) aufweist, die die Bauelemente (2,3a,3b) elektrisch miteinander verbinden, wobei mindestens ein Bauelement (2,3a) eine Beschichtung (15a,15b) mit einem Lack aufweist, wobei der Lack magnetisch leitende Partikel (15) enthält. Weiterhin betrifft die Erfindung ein Verfahren zur Herstellung einer solchen elektrischen Baugruppe (1). Die Erfindung ermöglicht auf ein Bauelement (2,3a,3b) einer elektrischen Baugruppe (1) einwirkende magnetische Felder und/oder von dem Bauelement (2,3a,3b) erzeugte magnetische Felder zu reduzieren.

## Beschreibung

Die Erfindung betrifft eine elektrische Baugruppe. Weiterhin betrifft die Erfindung ein Verfahren zur Herstellung einer elektrischen Baugruppe.

Aufgrund der immer weiter gehenden Erhöhung der Komplexität von elektrischen Schaltungen, welche auf einer elektrischen Baugruppe realisiert sind, steigen die Anforderungen an die Robustheit gegenüber auf die Baugruppe einwirkenden magnetischen Feldern. Gleichzeitig wird auch eine Verminderung von magnetischen Feldern, welche von den Bauelementen der Baugruppe selbst erzeugt werden, erwünscht.

Aus der DE 602 00 654 T2 ist ein Element zur elektromagnetischen Abschirmung und Verfahren zu seiner Herstellung bekannt.

Aus der EP 2 192 824 A1 ist eine Leiterplatte mit einer Beschichtung aus einem elektromagnetische Strahlungen dämpfenden Material bekannt.

Aus der DE 10 2004 028 603 A1 ist ein Verfahren zur Beschichtung einer Seite einer Leiterplatte, eine beschichtete Leiterplatte sowie ein Beschichtungs-Material bekannt.

Aus der DE 103 43 362 A1 ist ein Verfahren zur Herstellung einer Leiterplatte bekannt, bei dem eine mit einer ferritischen Dünnschicht versehene Folie mit einem Trägermaterial der Leiterplatte und anderen gegebenenfalls bereits auf das Trägermaterial aufgebrachte Schichten verpresst wird.

Es ist Aufgabe der Erfindung, auf ein Bauelement einer elektrischen Baugruppe einwirkende magnetische Felder und/oder von dem Bauelement erzeugte magnetische Felder zu reduzieren. Diese Aufgabe wird gelöst durch eine elektrische Baugruppe, wobei die Baugruppe eine Leiterplatte und auf der Leiterplatte angeordnete elektrische Bauelemente aufweist, wobei die Leiterplatte elektrisch leitende Leiterbahnen aufweist, die die Bauelemente elektrisch miteinander verbinden, wobei mindestens ein Bauelement eine Beschichtung mit einem Lack aufweist, wobei der Lack magnetisch leitende Partikel enthält. Weiterhin wird diese Aufgabe gelöst durch ein Verfahren zur Herstellung einer elektrischen Baugruppe, wobei elektrische Bauelemente auf einer Leiterplatte, welche elektrisch leitende Leiterbahnen aufweist, angeordnet werden, wobei auf mindestens ein Bauelement eine Beschichtung mit einem Lack aufgebracht wird, wobei der Lack magnetisch leitende Partikel enthält.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen der elektrischen Baugruppe und umgekehrt.

Es erweist sich als vorteilhaft, wenn auf das mindestens eine Bauelement eine Beschichtung mit einem Lack aufgebracht wird, indem der Lack auf das Bauelement aufsprüht wird. Durch Aufsprühen kann auf besonders einfache Art und Weise die Beschichtung des Bauelements mit dem Lack erzeugt werden.

Ferner erweist es sich als vorteilhaft, wenn auf das mindestens eine Bauelement eine Beschichtung mit einem Lack aufgebracht wird, indem das Bauelement in den Lack eingetaucht wird. Durch Aufbringen der Beschichtung mittels Eintauchen in den Lack kann das Bauelement besonders schnell mit der Beschichtung versehen werden und somit die elektrische Baugruppe besonders schnell hergestellt werden.

Weiterhin erweist es sich als vorteilhaft, wenn auf das mindestens eine Bauelement eine Beschichtung mit einem Lack aufgebracht wird, indem der Lack mit einem Pinsel auf das Bauelement aufgebracht wird, da die Beschichtung mittels eines Pinsels auf besonders einfache Art und Weise auf das Bauelement aufgebracht werden kann.

Ein Ausführungsbeispiel der Erfindung ist in der Zeichnung dargestellt und wird im Folgenden näher erläutert. Dabei zeigen:
- FIG 1: Eine erfindungsgemäße elektrische Baugruppe in Form einer schematisiert dargestellten Draufsicht auf die Baugruppe,
- FIG 2: eine schematisierte Schnittansicht der erfindungsgemäßen Baugruppe und
- FIG 3: eine Detailansicht von FIG 2.

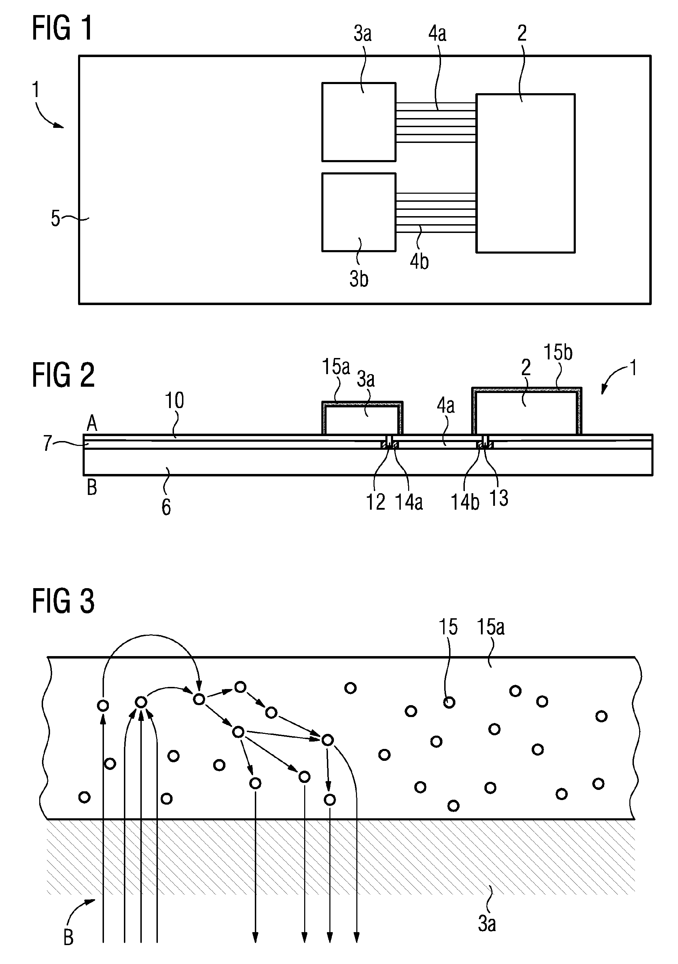

In FIG 1 ist in Form einer schematisierten Ansicht von oben eine Draufsicht auf die erfindungsgemäße Baugruppe 1 dargestellt. Die elektrische Baugruppe 1 weist eine Leiterplatte 5 und auf der Leiterplatte 5 angeordnete elektrische Bauelemente 2, 3a und 3b auf. Bei dem Bauelement 2 handelt es sich im Rahmen des Ausführungsbeispiels um einen Prozessor und bei den Bauelementen 3a und 3b um Speicherchips. Die elektrischen Bauelemente können aber auch z.B. in Form von Transformatoren, elektrischen Ventilen (z.B. Transistoren, IGBTs etc.), Kondensatoren oder elektrischen Widerständen vorliegen.

Die Bauelemente sind dabei über elektrische Leiterbahnen miteinander verbunden, wobei in FIG 1 der Übersichtlichkeit halber nur die Leiterbahnen 4a und 4b mit einem Bezugszeichen versehen sind.

In FIG 2 ist eine schematisierte Schnittansicht der erfindungsgemäßen Baugruppe 1 dargestellt. Die Leiterplatte weist eine Trägerplatte 6, eine Leiterbahnenschicht 7, welche die Leiterbahnen enthält, und eine Klarlackschicht 10 auf, welche zum Schutz der Leiterbahnen dient. Die in FIG 2 dargestellte Schnittansicht verläuft durch die Bauelemente 2, 3a und die Leiterbahn 4a. Das Bauelement 3a weist ein elektrisches Anschlusselement 12 (Pin) auf und das Bauelement 2 weist ein elektrisches Anschlusselement 13 (Pin) auf. Die Bauelemente 3a und 2 sind über Lötverbindungen 14a und 14b, über die Leiterbahn 4a, sowie über die Anschlusselemente 12 und 13 elektrisch leitend miteinander verbunden.

Erfindungsgemäß weisen, um beim Betrieb des Bauelements 3a und des Bauelements 2 entstehende magnetische Felder zu reduzieren, welche z.B. andere Bauelemente der Baugruppe stören könnten und/oder andere Baugruppen stören könnten, und/oder um von anderen Bauelementen erzeugte magnetische Felder welche auf die Bauelemente 2 und 3a einwirken zu reduzieren, die Bauelemente 2 und 3a eine Beschichtung 15a und 15b aus einem Lack auf, der magnetisch leitende Partikel enthält.

Die magnetisch leitenden Partikel bestehen dabei im Rahmen des Ausführungsbeispiels vorzugsweise aus einem ferromagnetischen Material, wie z.B. Eisen oder einer ferromagnetischen eisenhaltigen Legierung. Die magnetisch leitenden Partikel können aber auch aus einem ferrimagnetischen Material, wie z.B. aus einem ferrithaltigen Material bestehen.

In FIG 3 ist eine Detailansicht der Beschichtung 15a, welche auf das Bauelement 3a aufgebracht ist, dargestellt. Der Lack und somit die Beschichtung 15a weisen, wie schon gesagt, magnetisch leitende Partikel auf, wobei der Übersichtlichkeit halber in FIG 3 nur ein magnetisch leitender Partikel 15 mit einem Bezugszeichen versehen ist. Im Rahmen des Ausführungsbeispiels erzeugt das Bauelement 3a ein magnetisches Feld, dessen Magnetfeldlinien B in FIG 3 in Form von Pfeilen dargestellt sind. Die Magnetfeldlinien werden dabei zum größten Teil von den magnetisch leitenden Partikeln umgelenkt, so dass diese nur zu einem geringen Teil die Lackschicht durchstoßen.

Die erfindungsgemäße elektrische Baugruppe lässt sich besonders leicht herstellen. Hierzu werden in einem ersten Schritt zunächst die elektrischen Bauelemente auf der Leiterplatte, welche die elektrisch leitende Leiterbahn aufweist, angeordnet und vorzugsweise an ihren elektrischen Anschlusselementen mit den elektrisch leitenden Leiterbahnen verlötet. Anschließend wird der Lack, der die magnetisch leitenden Partikel enthält, auf die betreffenden Bauelemente, bei denen das magnetische Feld reduziert werden soll, mittels z.B. einer Düse aufgesprüht. Alternativ hierzu können zur Beschichtung die Bauelemente auch in den Lack, der die magnetisch leitenden Partikel enthält, eingetaucht werden. Weiterhin kann alternativ der Lack auch mittels eines Pinsels auf die betreffenden Bauelemente aufgebracht werden.

Es sei an dieser Stelle angemerkt, dass selbstverständlich der Lack, der magnetisch leitende Partikel enthält, auch auf alle Bauelemente der Baugruppe aufgebracht werden kann und alle Bauelemente der Baugruppe somit mit dem Lack beschichtet werden können.

Durch die Erfindung wird kein zusätzlicher Platz auf der Baugruppe oder über der Baugruppe benötigt um eine Reduzierung der magnetischen Felder zu erzielen.

## Patentansprüche

1. Elektrische Baugruppe, wobei die Baugruppe (1) eine Leiterplatte (5) und auf der Leiterplatte (5) angeordnete elektrische Bauelemente (2,3a,3b) aufweist, wobei die Leiterplatte (5) elektrisch leitende Leiterbahnen (4a,4b) aufweist, die die Bauelemente (2,3a,3b) elektrisch miteinander verbinden, wobei mindestens ein Bauelement (2,3a) eine Beschichtung (15a,15b) mit einem Lack aufweist, wobei der Lack magnetisch leitende Partikel (15) enthält.

2. Verfahren zur Herstellung einer elektrischen Baugruppe (1), wobei elektrische Bauelemente (2,3a,3b) auf einer Leiterplatte (5), welche elektrisch leitende Leiterbahnen (4a,4b) aufweist, angeordnet werden, wobei auf mindestens ein Bauelement (2,3a) eine Beschichtung (15a,15b) mit einem Lack aufgebracht wird, wobei der Lack magnetisch leitende Partikel (15) enthält.

3. Verfahren nach Anspruch 2,
**dadurch gekennzeichnet, dass** auf das mindestens eine Bauelement (2,3a) eine Beschichtung (15a,15b) mit einem Lack aufgebracht wird, indem der Lack auf das Bauelement (2,3a) aufsprüht wird.

4. Verfahren nach Anspruch 2,
**dadurch gekennzeichnet, dass** auf das mindestens eine Bauelement (2,3a) eine Beschichtung (15a,15b) mit einem Lack aufgebracht wird, indem das Bauelement (2,3a) in den Lack eingetaucht wird.

5. Verfahren nach Anspruch 2,
**dadurch gekennzeichnet, dass** auf das mindestens eine Bauelement (2,3a) eine Beschichtung (15a,15b) mit einem Lack aufgebracht wird, indem der Lack mit einem Pinsel auf das Bauelement (2,3a) aufgebracht wird.
